# EUROPÄISCHE PATENTSCHRIFT

(11) **EP 2 250 299 B1**
(45) Veröffentlichungstag und Bekanntmachung des Hinweises auf die Patenterteilung: **22.10.2014**
(21) Anmeldenummer: 09719660.4
(22) Anmeldetag: 20.01.2009
(51) Int. Cl.: C23C 16/24, C23C 16/32, C23C 16/34, C23C 16/36, C23C 18/04, C23C 30/00, C04B 35/581, C23C 28/04, C23C 28/00

(54) **HARTSTOFFBESCHICHTETER KÖRPER**
BODY COATED WITH HARD MATERIAL
OBJET REVÊTU D'UN MATÉRIAU DUR

(30) Priorität: 12.03.2008 DE 102008013966
(43) Veröffentlichungstag der Anmeldung: 17.11.2010
(73) Patentinhaber: KENNAMETAL INC., Latrobe, PA 15650 (US)
(72) Erfinder: VAN DEN BERG, Hendrikus, NL-5925 BT Venlo-Blerick (NL); WESTPHAL, Hartmut, 36466 Dermbach/Rhöhn (DE); SOTTKE, Volkmar, 45479 Mühlheim/Ruhr (DE)
(74) Vertreter: Vomberg, Friedhelm
(86) Internationale Anmeldenummer: PCT/EP2009/000310
(87) Internationale Veröffentlichungsnummer: WO 2009/112116

(56) Entgegenhaltungen:
- EP-A- 1 757 389
- WO-A-2007/003648
- US-A1- 2002 136 933
- LEE S-H ET AL: "(TI1-XALX)N COATINGS BY PLASMA-ENHANCED CHEMICAL VAPOR DEPOSITION" JOURNAL OF VACUUM SCIENCE AND TECHNOLOGY: PART A, AVS /AIP, MELVILLE, NY.; US, Bd. 12, Nr. 4, 1. Juli 1994 (1994-07-01), Seiten 1602-1607, XP000608885 ISSN: 0734-2101
- I. ENDLER, M. HÖHN, M. HERRMANN, R. PITONAK, S. RUPPI, M. SCHNEIDER, H. VAN DEN BERG AND H. WESTPHAL: "Novel aluminum-rich Ti1-xAlxN coatings by LPCVD" SURFACE AND COATINGS TECHNOLOGY, Bd. 203, Nr. 5-7, 25. Dezember 2008 (2008-12-25), Seiten 530-533, XP002524222

## Beschreibung

Die Erfindung betrifft einen hartstoffbeschichteten Körper mit mindestens einer mittels CVD aufgetragener Hartstoffschicht.

An Schneidwerkzeuge, die für die zerspanende Bearbeitung verwendet werden, werden hohe Anforderungen hinsichtlich der Standfestigkeit und der Belastbarkeit gestellt, insbesondere bei der Zerspanung harter oder zäher Materialien wie vergüteten bzw. gehärteten Stählen durch Drehen mit hohen Schnittgeschwindigkeiten. Der Schneidwerkstoff soll insbesondere abrasionsbeständig sein, was bereits frühzeitig dazu führte, dass Hartmetall- oder Cermetsubstratkörper mit Oberflächenbeschichtungen versehen worden sind, wobei zunächst Carbide, Nitride oder Carbonitride des Titans und später auch Aluminiumoxidschichten als Verschleißschutzschichten verwendet worden sind. Bekannt sind auch mehrlagige Verschleißschutzschichten aus unterschiedlichen Hartstoffen. Als verschleißmindernde Schichten sind beispielsweise Aluminiumoxidschichten bekannt, die auf einer oder mehreren Zwischenlagen wie beispielsweise Titancarbonitrid oder Titannitrid angeordnet sind.

Aus der WO 03/085152 A2 ist die Verwendung einer Ti-Al-N-Schicht bekannt, die als monophasige Schicht mit Aluminiumgehalten bis 60% mittels PVD erzeugt werden kann. Bei höheren Aluminiumgehalten entsteht allerdings ein Gemisch aus kubischen und hexagonalen TiAlN und bei noch höheren Aluminiumanteilen nur noch die weichere und nicht verschleißfeste hexagonale Wurtzitstrucktur.

Es ist auch bekannt, dass mittels Plasma-CVD einphasige Ti₁₋ₓAlₓ-N-Hartstoffschichten mit x= 0,9 herstellbar sind. Nachteilig sind jedoch hierbei die unzureichende Homogenität der Schichtzusammensetzung und der relativ hohe Chlorgehalt in der Schicht.

Soweit für die Herstellung von Ti₁₋ₓAlₓN-Hartstoffschichten PVD- oder Plasma-CVD-Verfahren eingesetzt wurden, war deren Anwendung auf Temperaturen unter 700°C beschränkt. Nachteilig ist, dass die Beschichtung komplizierter Bauteilgeometrien Schwierigkeiten bereitet. PVD ist ein gerichteter Prozess, bei dem komplexe Geometrien unregelmäßig beschichtet werden. Das Plasma-CVD erfordert eine hohe Plasmahomogenität, da die Plasmaleistungsdichte einen direkten Einschluss auf das Ti/Al-Atomverhältnis der Schicht hat. Die Herstellung einphasiger kubischer Ti₁₋ₓAlₓ-N-Schichten mit hohem Aluminiumanteil ist mit den industriell eingesetzten PVD-Verfahren nicht möglich.

Auch eine TiAl-Abscheidung mit einem konventionellen CVD-Verfahren bei Temperaturen über 1.000°C ist nicht möglich, da das methastabilie Ti₁₋ₓAlₓN bei solch hohen Temperaturen in TiN und hexagonalem AIN zerfällt.

Schließlich ist bei dem in der US 6,238,739 B1 beschriebenen Verfahren, durch einen thermischen CVD-Prozess ohne Plasmaunterstützung Ti₁₋ₓAlₓN-Schichten mit x zwischen 0,1 und 0,6 bei Temperaturen zwischen 550°C und 650°C herzustellen, eine Eingrenzung auf kleinere Aluminiumgehalte mit x ≤0,6 gegeben. Als Gasmischung werden in dem dort beschriebenen Prozess Aluminium- und Titanchloride sowie NH₃ und H₂ verwendet. Auch bei dieser Beschichtung sind hohe Chlorgehalte bis zu 12 At% in Kauf zu nehmen.

In der WO 2007/003648 A1 wird zur Verbesserung der Verschleißfestigkeit und der Oxidationsbeständigkeit vorgeschlagen, einen hartstoffbeschichteten Körper mit einem ein- oder mehrlagigen Schichtsystem mittels CVD herzustellen, das mindestens eine Ti₁₋ₓAlₓN-Hartstoffschicht enthält, wozu der Körper in einem Reaktor bei Temperaturen im Bereich von 700°C bis 900°C mittels CVD ohne Plasmaanregung beschichtet wird und als Precursoren Titanhallogenide, Aluminiumhallogenide und reaktive Stickstoffverbindungen Verwendung finden sollen, die bei erhöhter Temperatur gemischt werden. Im Ergebnis wird ein Körper mit einer einphasigen Ti₁₋ₓAlₓN-Hartstoffschicht in der kubischen NaCl-Struktur mit einem Stöchiometriekoeffizienten x > 0,75 bis x = 0,93 oder eine mehrphasige Schicht erhalten, deren Hauptphase aus Ti₁₋ₓAlₓN mit kubischer NaCl-Struktur mit einem Stöchiometriekoeffizienten x > 0,75 bis x = 0,93 und als weitere Phase eine Wurtzitstruktur und/oder TiNₓNaCl-Struktur besitzt. Der Chlorgehalt liegt im Bereich zwischen 0,05 bis 0,9 At%. Aus diesem Dokument ist auch bekannt, dass die Ti₁₋ₓAlₓN-Hartstoffschicht oder Schichten bis zu 30 Massen% amorphe Schichtbestandteile enthalten können. Der Härtewert der erhaltenen Schichten liegt im Bereich 2.500 HV bis 3.800 HV.

Um die Haftung einer Ti₁₋ₓAlₓN-Hartstoffschicht bei hoher Verschleißfestigkeit zu verbessern, wird in der nicht vorveröffentlichten DE 10 2007 000 512 zudem vorgeschlagen, dass das auf einen Substratkörper aufgetragene Schichtsystem aus einer auf den Körper aufgebrachten Anbindungsschicht aus Titannitrid, Titancarbonitrid oder Titancarbid besteht, worauf eine Phasengradientenschicht folgt und schließlich eine Außenlage aus einer ein- oder mehrphasigen Ti₁₋ₓAlₓN-Hartstoffschicht. Die Phasengradientenschicht besteht an ihrer der Anbindungsschicht zugewandten Seite aus einem TiN/h-AIN-Phasengemisch und weist mit zunehmender Schichtdicke einen zunehmenden Phasenanteil von fcc-TiAlN mit einem Anteil von mehr als 50% und damit einhergehend simultaner Abnahme der Phasenanteile von TiN und h-AlN auf.

Nachteilig bei den vorerwähnten Beschichtungen sind die geringen Standzeiten bei unterbrochenen Schnitten wie dem Fräsen, Drehen und Bohren mit Schnittunterbrechung, insbesondere soweit beim Schneiden Kühlschmiermittel verwendet werden.

Es ist daher Aufgabe der vorliegenden Erfindung, einen hartstoffbeschichteten Körper anzugeben, der eine verbesserte Temperatur- und Lastwechselbeständigkeit aufweist.

Diese Aufgabe wird durch den hartstoffbeschichteten Körper nach Anspruch 1 gelöst. Dieser Körper ist dadurch gekennzeichnet, dass die äußere Schicht aus Ti₁₋ₓAlₓN, Ti₁₋ₓAlₓC und/oder Ti₁₋ₓAlₓCN mit 0,65 ≤x ≤0,9, vorzugsweise 0,7 ≤x ≤0,9 besteht und dass diese äußere Schicht Druckspannungen zwischen 100 und 1.100 MPa, vorzugsweise zwischen 400 und 800 MPa aufweist, und dass unter dieser äußeren Schicht eine TICN- oder Al₂O₃-Schicht angeordnet ist.

Eine Schicht aus Ti₁₋ₓAlₓN, Ti₁₋ₓAlₓC oder Ti₁₋ₓAlₓCN, die mittels CVD aufgetragen wird, zeigt sich als äußerst beständig gegen eine Rissbildung und eine Rissausbreitung, die bei anderen nach dem Stand der Technik bekannten und verwendeten Beschichtung anzutreffen ist. Die als Substratgrundkörper verwendeten Hartmetalle, Cermets oder Keramiken haben gegenüber TiCN und Al₂O₃ kleinere Ausdrehungkoeffizienten, wodurch bei Abkühlen von Beschichtungstemperaturen um 900°C für TiCN und um 1.000°C für Al₂O₃ Zugspannungen in diesen Hartstoffschichten entstehen, die sich teilweise durch die Ausbildung von Rissstrukturen abbauen. Kubisches Titanaluminiumnitrid oder Titanaluminiumcarbonitrid weist als metastabiles Kristallsystem nach der Abkühlung von den Beschichtungstemperaturen Druckspannungen zwischen 100 und 1.100 MPa, vorzugsweise zwischen 400 und 800 MPa auf und bildet keine Rissstruktur aus, was insgesamt dazu führt, dass sich diese Kombination der in Anspruch 1 benannten Schichten als äußerst verschleißbeständig erweist. Durch die Kombination der bekannt hohen Abrasionsbeständigkeiten des TICN und der geringen Wärmeleitfähigkeit und hohen Oxidationsbeständigkeit des Al₂O₃ mit der ebenfalls sehr abrasions- und oxidationsbeständigen Titanaluminiumnitrid- oder Titanaluminiumcarbonitrid-Beschichtung als äußerer Schicht mit Druckeigenspannungen wird die Schneidhaltigkeit bei Anwendungen signifikant verbessert, die hohe Lastwechsel und hohe Temperaturwechsel bedingen. Beispiele hierfür sind das Fräsen sowie das Drehen und Bohren mit Unterbrechungen oder wechselnden Spanquerschnitten, insbesondere bei der Verwendung von Kühlschmiermitteln.

Weiterbildungen der vorliegenden Erfindung sind in den Unteransprüchen beschrieben.

So kann die Ti₁₋ₓAlₓN-Schicht, die Ti₁₋ₓAlₓC-Schicht oder die Ti₁₋ₓAlₓCN-Schicht einphasig sein und eine kubische Struktur aufweisen oder mehrphasig sein und neben einer kubischen Hauptphase eine weitere Phase in Wurtzitstruktur aufweisen und/oder TiN in NaCl-Struktur.

Die vorgenannte Titanaluminiumnitrid- oder -carbonitridschicht kann bis zu 30 Massen% amorphe Schichtbestandteile besitzen. Vorzugsweise liegt der Chlorgehalt der Titanaluminiumnitrid- oder Titanaluminiumcarbonitrid-Schicht zwischen 0,01 und 3 At%.

Nach einer weiteren Ausgestaltung der vorliegenden Erfindung kann auch als äußere Schicht eine mehrlagige Schicht verwendet werden, die aus jeweils 1 nm bis 5 nm dicken Lagen gleicher oder wechselnder, vorzugsweise alternierender Zusammensetzung besteht. Die einzelnen Lagen sind Titanaluminiumcarbonitrid und Titanaluminiumnitrid-Lagen, wobei die Gesamtdicke dieser Lagen, welche die äußerste Schicht bildet, zwischen 1 µm und 5 µm liegt.

Durch wechselnde Gasatmosphäre bei fortlaufender Beschichtung kann in den einzelnen Lagen auch ein Gradient geschaffen werden, durch den der Kohlenstoffgehalt von innen nach außen stetig in Teilbereichen steigt oder fällt. Die Gesamtdicke aller Schichten, die auf dem Substratkörper aus Hartmetall, Cermet oder einer Keramik aufgetragen wird, soll zwischen 5 µm und 25 µm liegen.

Im Rahmen der vorliegenden Erfindung kann die Titanaluminiumnitrid- oder Titanaluminiumcarbonitrd-Schicht bis zu 25% hexagonaler Anteile an AIN enthalten.

Zur Herstellung des erfindungsgemäßen hartstoffbeschichteten Körpers wird ein Hartmetall- oder Cermetkörper bei Beschichtungstemperaturen zwischen 700°C und 900°C in eine Gasatmosphäre eingebracht, die neben Trägergasen zum Auftrag von TiCN Titanchlorid, Methan und Ammoniak oder zum Auftrag von Aluminiumoxid Aluminiumchlorid und Kohlendioxid enthält. Nach Fertigstellung einer Anbindungsschicht auf einem der genannten Substrate oder einer TiCN-Basisschicht, worauf eine Al₂O₃-Schicht aufgetragen wird, wird zum Auftrag der äußersten Schicht in die Gasatmosphäre Aluminiumchlorid, Titanchlorid, Ammoniak und Ethen eingelassen. Bevorzugte Schichtdicken liegen zwischen 2 und 5 µm. Die Schichtdicke aller Schichten beträgt 2 bis 10 µm, vorzugsweise 3 bis 7 µm.

## Patentansprüche

1. Hartstoffbeschichteter Körper mit mehreren mittels CVD aufgetragenen Schichten, wobei
die äußere Schicht aus Ti₁₋ₓAlₓN, Ti₁₋ₓAlₓC und/oder Ti₁₋ₓAlₓCN mit 0,65 ≤x ≤0,9, vorzugsweise 0,7 ≤x ≤0,9 besteht, und diese äußere Schicht Druckspannungen zwischen 100 und 1.100 MPa, vorzugsweise zwischen 400 und 800 MPa aufweist, und unter dieser äußeren Schicht eine TiCN- oder Al₂O₃-Schicht angeordnet ist.

2. Hartstoffbeschichteter Körper nach Anspruch 1, **dadurch gekennzeichnet, dass** die Ti₁₋ₓAlₓN-Schicht, die Ti₁₋ₓAlₓC-Schicht oder die Ti₁₋ₓAlₓCN-Schicht einphasig ist und eine kubische Struktur aufweist oder mehrphasig ist und neben einer kubischen Hauptphase eine weitere Phase in Wurtzitstruktur aufweist und/oder TiN aufweist.

3. Hartstoffbeschichteter Körper nach Anspruch 1 oder 2, **dadurch gekennzeichnet, dass** bis zu 30 Massen% amorphe Schichtbestandteile in der äußeren Schicht enthalten sind.

4. Hartstoffbeschichteter Körper nach einem der Ansprüche 1 bis 3, **dadurch gekennzeichnet, dass** der Chlorgehalt der äußeren Schicht zwischen 0,01 und 3 At% liegt.

5. Hartstoffbeschichteter Körper nach einem der Ansprüche 1 bis 4, **dadurch gekennzeichnet, dass** die äußere Schicht aus mehreren, jeweils 1 bis 5 nm dicken Lagen gleicher oder wechselnder, vorzugsweise alternierender Zusammensetzung, ausgewählt aus Ti₁₋ₓAlₓN, Ti₁₋ₓAlₓC oder Ti₁₋ₓAlₓCN, besteht und dass diese äußere Schicht eine Gesamtdicke von 1 µm bis 5 µm aufweist.

6. Hartstoffbeschichteter Körper nach einem der Ansprüche 1 bis 5, **dadurch gekennzeichnet, dass** die Gesamtdicke aller Schichten, die auf einem Substratkörper aus Hartmetall, Cermet oder einer Keramik aufgetragen worden sind, zwischen 5 µm und 25 µm liegt.

7. Hartstoffbeschichteter Körper nach einem der Ansprüche 1 bis 6, **dadurch gekennzeichnet, dass** die Ti₁₋ₓAlₓN-Schicht, die Ti₁₋ₓAlₓC-Schicht oder die Ti₁₋ₓAlₓCN-Schicht bis zu 25% hexagonale Anteile an AIN enthält.

## Claims

1. Body which is coated with hard material and has a plurality of layers applied by means of CVD, the outer layer comprising Ti₁₋ₓAlₓN, Ti₁₋ₓAlₓC and/or Ti₁₋ₓAlₓCN where 0.65 ≤ x ≤ 0.9, preferably 0.7 ≤ x ≤ 0.9, and this outer layer having compressive stresses in the range from 100 to 1100 MPa, preferably from 400 to 800 MPa, and a TiCN or Al₂O₃ layer being arranged under this outer layer.

2. Body coated with hard material according to Claim 1, **characterized in that** the Tl₁₋ₓAlₓN layer, the Ti₁₋ₓAlₓC layer or the Ti₁₋ₓAlₓCN layer consists of a single phase and has a cubic structure or consists of a plurality of phases and comprises a cubic main phase together with a further phase having the wurtzite structure and/or comprises TiN.

3. Body coated with hard material according to Claim 1 or 2, **characterized in that** up to 30% by mass of amorphous layer constituents are present in the outer layer.

4. Body coated with hard material according to any of Claims 1 to 3, **characterized in that** the chlorine content of the outer layer is in the range from 0.01 to 3 atom%.

5. Body coated with hard material according to any of Claims 1 to 4, **characterized in that** the outer layer comprises a plurality of layers which each have a thickness of from 1 to 5 nm and have an identical or changing, preferably alternating composition selected from among Ti₁₋ₓAlₓN, Ti₁₋ₓAlₓC and Ti₁₋ₓAlₓCN and **in that** this outer layer has a total thickness of from 1 µm to 5 µm.

6. Body coated with hard material according to any of Claims 1 to 5, **characterized in that** the total thickness of all layers which have been applied to a substrate body composed of cemented carbide, cermet or a ceramic is in the range from 5 µm to 25 µm.

7. Body coated with hard material according to any of Claims 1 to 6, **characterized in that** the Ti₁₋ₓAlₓN layer, the Ti₁₋ₓAlₓC layer or the Ti₁₋ₓAlₓCN layer contains up to 25% of hexagonal AlN.

## Revendications

1. Corps revêtu par une substance dure présentant plusieurs couches appliquées par dépôt chimique en phase vapeur (CVD), la couche externe étant constituée de Ti₁₋ₓAlₓN, de Ti₁₋ₓAlₓC et/ou de Tl₁₋ₓAlₓCN avec 0,65 ≤ x ≤ 0,9, de préférence 0,7 ≤ x ≤ 0,9, et cette couche externe présentant des contraintes de compression entre 100 et 1100 MPa, de préférence entre 400 et 800 MPa et une couche de TiCN ou d'Al₂O₃ étant disposée sous cette couche externe.

2. Corps revêtu par une substance dure selon la revendication 1, **caractérisé en ce que** la couche de Ti₁₋ₓAlₓN, de Ti₁₋ₓAlₓC ou de Ti₁₋ₓAlₓCN est à une phase et présente une structure cubique ou est à plusieurs phases et présente, outre une phase principale cubique, une autre phase dans la structure de Wurtzite et/ou du TiN.

3. Corps revêtu par une substance dure selon la revendication 1 ou 2, **caractérisé en ce que** la couche externe contient jusqu'à 30% en masse de constituants de couche amorphes.

4. Corps revêtu par une substance dure selon l'une quelconque des revendications 1 à 3, **caractérisé en ce que** la teneur en chlore de la couche externe est située entre 0,01 et 3% en atome.

5. Corps revêtu par une substance dure selon l'une quelconque des revendications 1 à 4, **caractérisé en ce que** la couche externe est constituée par plusieurs couches, présentant à chaque fois une épaisseur de 1 à 5 nm, de composition identique ou variable, de préférence alternée, choisie parmi Ti₁₋ₓAlₓN, Ti₁₋ₓAlₓC ou Ti₁₋ₓAlₓCN et **en ce que** cette couche externe présente une épaisseur totale de 1 µm à 5 µm.

6. Corps revêtu par une substance dure selon l'une quelconque des revendications 1 à 5, **caractérisé en ce que** l'épaisseur totale de toutes les couches, qui sont appliquées sur un corps de substrat en métal dur, en cermet ou en céramique, est située entre 5 µm et 25 µm.

7. Corps revêtu par une substance dure selon l'une quelconque des revendications 1 à 6, **caractérisé en ce que** la couche de Ti₁₋ₓAlₓN, de Ti₁₋ₓAlₓC ou de Ti₁₋ₓAlₓCN contient jusqu'à 25% de proportions hexagonales en AlN.
